(19) Europäisches Patentamt
European Patent Office
Office européen des brevets

(11) EP 0 896 373 A2

(12) **EUROPEAN PATENT APPLICATION**

(43) Date of publication:
10.02.1999 Bulletin 1999/06

(51) Int Cl.⁶: **H01L 31/18**, H01L 21/3213

(21) Application number: 98306294.4

(22) Date of filing: 06.08.1998

(84) Designated Contracting States:
**AT BE CH CY DE DK ES FI FR GB GR IE IT LI LU
MC NL PT SE**
Designated Extension States:
**AL LT LV MK RO SI**

(30) Priority: 08.08.1997 JP 214754/97
14.10.1997 JP 280700/97
06.11.1997 JP 304602/97
26.03.1998 JP 79819/98
28.05.1998 JP 148092/98
05.06.1998 JP 157342/98

(71) Applicant: **MITSUI CHEMICALS, INC.**
**Tokyo (JP)**

(72) Inventors:
• Sadamoto, Mitsuru
Yokohama-shi, Kanagawa (JP)
• Yanagawa, Noriyuki
Hadano-shi, Kanagawa (JP)
• Iwamori, Satoru
Yokohama-shi, Kanagawa (JP)
• Sasaki, Kenju
Mobara-shi, Chiba (JP)

(74) Representative: **Nicholls, Kathryn Margaret et al**
**MEWBURN ELLIS**
**York House**
**23 Kingsway**
**London WC2B 6HP (GB)**

(54) **Dry etching method of metal oxide/photoresist film laminate**

(57)    Dry etching of a metal oxide film exposed without being coated with a photoresist is carried out with plasma of a gas obtained by mixing hydrogen iodide with at least one gas selected from the group consisting of a group consisting of fluorine gas and fluorine-based compound gases and a group consisting of nitrogen gas and nitrogen-based compound gases, and then after the exposing of the above mentioned photoresist film to plasma of oxygen gas, the remaining photoresist film is removed by etching with plasma of a gas obtained by mixing oxygen gas with at least one gas selected from the group consisting of a group consisting of fluorine gas and fluorine-based compound gases and a group consisting of nitrogen gas and nitrogen-based compound gases. Volume flow rate conditions of hydrogen iodide gas or oxygen gas and the gas selected from the group consisting of a group consisting of fluorine gas and fluorine-based compound gases and a group consisting of nitrogen gas and nitrogen-based compound gases are prescribed in specific ranges.

## Description

The present invention relates to a dry etching method and specifically to a method of etching of a metal oxide film such as an indium tin oxide (hereinafter referred to as ITO) film with a gas comprising mainly hydrogen iodide gas and of removing remaining photoresist film formed thereon in order to form a pattern by etching.

An ITO thin film which is one of metal oxide thin films is used for pixel electrodes of a liquid crystal display, and a placing method thereof includes a top ITO method in which an ITO thin film is placed at the front side of TFT and a bottom ITO method in which ITO is placed at the back side. In either case, a finer processing technique is required, and patterning is required to provide an ITO thin film with an area prescribed for the electrode and to place it in a prescribed position. A wet etching method using acids such as hydrochloric acid, aqua regia and ferric chloride is mainly used at present, and further finer processing has been required in accordance with demands for high definition of a liquid crystal display.

In accordance with demands for high definition, a processing width has to be reduced to, for example, 4 $\mu$m or less and to about 1 $\mu$m in the near future. If wet etching is used, demands for such fine processing can not be met. In division processing of a pixel electrode, a partition is placed between adjacent one-unit pixels, and this partition prevents an image from transferring from adjacent pixels. By reducing a width of this partition part as much as possible, an area of a pixel electrode can be enlarged, but this requires fine etching processing. In the top ITO method in which an ITO thin film is placed at the front side of TFT, a wet etching method has a high risk of cutting a metal aluminum wiring layer, and this causes a reduction in the yield. Accordingly, a dry etching method has been adopted.

Further, there is a problem in wet etching in that etching residues float and remain on a device. Accordingly, an etchant has to be frequently exchanged, which results in consuming the etchant in a large quantity.

For these reasons, wet etching is substituted by dry etching, and it is considered that dry etching will become the mainstream as well in etching of ITO in the future.

With respect to dry etching for metal oxides as a main substance, dry etching of ITO with hydrogen iodide gas is reported in Journal of Electrochemical Society (J. Electrochem. Soc. Vol. 136, No. 6, June 1989) to show good results.

Further, an example in which dry etching of zinc oxide (ZnO) was carried out with hydrogen iodide gas is reported in Ultrasonic Symposium (IEEE 1982 Ultrasonics Symposium Proceedings, 346 1982) held in 1982.

These reports show that hydrogen iodide gas is suitable for dry etching of metal oxides such as ITO and ZnO.

Usually used as dry etching of ITO is an RIE (reactive ion etching) method in which etching is carried out by placing a substrate on a power electrode using a capacitance coupling type high-frequency power source of 13.56 MHz.

Gases used for dry etching include a mixed gas of methane ($CH_4$) and hydrogen ($H_2$), chlorine ($Cl_2$) gas and hydrogen bromide (HBr) gas. However, methods that use these gases have problems in that there is a great possibility that the etching capacity may depend on the system and that a range in which good etching characteristics are obtained is narrow and the etching speed is slow. Further, there is also a problem in that residual substances remain on a substrate. Residual substances are particularly problematic when a mixed gas of methane and hydrogen is used or when methane and argon gas are used. When this methane-based gas is used, a resist used as a protective coat in dry etching of ITO turns into non-volatile substances and scatters to the circumference to become residual substances, which are problematic.

In contrast with this, an etching method using hydrogen iodide gas is characterized in that dependency on the system is small and the etching speed is fast as compared with that of the gas systems described above. Further, it is at least characterized in that residual substances do not remain at least on a substrate, and therefore the etching method using hydrogen iodide gas is becoming the mainstream at present.

Dry etching of ITO with hydrogen iodide gas is disclosed in Japanese Patent Application Laid-Open No. Hei 5-251400. Also, it is disclosed in Japanese Patent Application Laid-Open No. Hei 6-151380 that etching can be carried out with a mixed gas of hydrogen iodide and $BCl_3$. Further, it is disclosed in Japanese Patent Application Laid-Open No. Hei 8-97190 that when argon gas is used in a mixture with hydrogen iodide gas, the etching speed is as high as 800 to 900 Å/minute. It is disclosed as well that no residue remains on a substrate and very good etching is possible.

However, as dry etching is carried out with hydrogen iodide gas, yellow and white non-volatile substances begin to stick to the wall of an apparatus and finally hinders etching per se.

Accordingly, after carrying out etching a certain number of times, a chamber is opened to wipe off yellow and white non-volatile substances stuck therein with alcohol based volatile chemicals.

In carrying out etching with a gas comprising mainly hydrogen iodide gas, a photoresist comprising a polymer is coated onto ITO to protect a pattern. This photoresist becomes firm after etching with plasma of hydrogen iodide and exerts great efficacy on maintaining its shape though thin. Accordingly, dry etching with hydrogen iodide is expected to show a good characteristic as well in processing the shape, so that dry etching is becoming more important.

On the other hand, a conventional photoresist comprises a polymer and can readily be removed with plasma of oxygen gas in the same may as dry etching. However, a photoresist exposed to plasma of hydrogen iodide gas is hard to be removed by etching with conventional oxygen plasma. A method of dry etching with hydrogen iodide gas does not become effective for the original purpose of patterning of a metal oxide film as long as such photoresist can not be effectively removed.

Japanese Patent Application Laid-Open No. Hei 8-146466 gives one solution to this problem. In this method, a photoresist is used for patterning processing of ITO, and hydrogen iodide is used for etching of ITO. In this patent application, etching processing is finished by that the photoresist is peeled by wet etching after exposed to oxygen. This is due to that after etching with hydrogen iodide gas, an iodine element sticks to a photoresist surface and a large amount of iodine is put into the photoresist so that the photoresist film is prevented from being removed by oxygen etching.

Accordingly, it is difficult to carry out all etching steps including removal of a photoresist by a dry method.

Embodiments of the present invention would desirably provide a method of carrying out etching without producing non-volatile substances in dry etching to carry out improved dry etching of metal oxides with hydrogen iodide gas and facilitating removal of the photoresist (eg by improving the speed of the process and avoiding or minimising damage to the metal oxide film which is the base coat).

The inventors have developed a method in which the non-have resulted in developing a method in which the non-volatile substances described above are inhibited from being produced by etching a metal oxide with a gas comprising mainly hydrogen iodide obtained by mixing with fluorine gas and fluorine-based compound gases (fluorine-based gases) and/or nitrogen gas and nitrogen-based compound gases (nitrogen-based gases) and in which after etching of a metal oxide with a gas comprising mainly hydrogen iodide gas, a photoresist comprising a polymer required for patterning is efficiently removed by etching with a gas prepared by mixing a fluorine-based gas and a nitrogen-based gas with oxygen gas, and thus the present inventors have come to complete the present invention. As a result, it has come to contribute to a rise in the productivity sharply.

That is, the present invention relates to:

(1) a dry etching method for a metal oxide/photoresist film laminate in which a metal oxide film is processed by dry etching with plasma of a gas containing hydrogen iodide at a pressure ranging from 0.1 to 50 Pa with a photoresist film being used as a mask and then the photoresist film is removed with plasma of a gas containing oxygen at a pressure ranging from 0.1 to 1000 Pa to carry out circuit patterning in the metal oxide film, wherein the gas containing hydrogen iodide is prepared by mixing hydrogen iodide with at least one gas selected from the group consisting of a group consisting of fluorine gas and fluorine-based compound gases and a group consisting of nitrogen gas and nitrogen-based compound gases,

(2) a dry-etching method for a metal oxide/photoresist film laminate as described in the above item (1), wherein a range in which $X_{FI}$ and $Y_{NI}$ satisfy is prescribed by equations (1), (2) and (3):

$$0.0004 \leqq X_{FI}^2 + Y_{NI}^2 \leqq 0.045 \qquad (1)$$

$$X_{FI} \geqq 0 \qquad (2)$$

$$Y_{NI} \geqq 0 \qquad (3)$$

wherein a volume flow rate of hydrogen iodide gas is designated as $G_{HI}$; a volume flow rate of a gas selected from the group consisting of fluorine gas and fluorine-based compound gases is designated $G_{FI}$; a volume flow rate of a gas selected from the group consisting of nitrogen gas and nitrogen-based compound gases is designated as $G_{NI}$; and a volume flow ratio $X_{FI}$ is defined by $X_{FI} = G_{FI}/G_{HI}$, and a volume flow ratio $Y_{NI}$ is defined by $Y_{NI} = G_{NI}/G_{HI}$,

(3) a dry-etching method for a metal oxide/photoresist film laminate as described in the above item (2), wherein a range in which $Z_{FNI}$ satisfy is prescribed by an equation (4):

$$0.02 \leqq Z_{FNI} \leqq 0.15 \qquad (4)$$

wherein a volume flow rate of hydrogen iodide gas is designated as $G_{HI}$; a volume flow rate of a gas selected from the group consisting of fluorine·nitrogen-based compound gases is designated as $G_{FNI}$; and a volume flow ratio $Z_{FNI}$ is defined by $Z_{FNI} = G_{FNI}/G_{HI}$,

(4) a dry etching method for a metal oxide/photoresist film laminate as described in the above item (1) in which a metal oxide film is processed by dry etching with a gas containing hydrogen iodide as described above and then a photoresist film is removed with plasma of a gas containing oxygen at a pressure ranging from of 0.1 to 1000 Pa, wherein the gas containing oxygen is prepared by mixing oxygen with at least one gas selected from the group consisting of a group consisting of fluorine gas and fluorine-based compound gases and a group consisting of nitrogen gas and nitrogen-based compound gases,

(5) a dry etching method for a metal oxide/photoresist film laminate as described in the above item (4), wherein a range in which $X_{FO}$ and $Y_{NO}$ satisfy is prescribed by equations (5), (6) and (7):

$$0.05 \leqq X_{FO} + Y_{NO} \leqq 6.0 \tag{5}$$

$$X_{FO} \geqq 0 \tag{6}$$

$$Y_{NO} \geqq 0 \tag{7}$$

wherein a volume flow rate of oxygen gas is designated as $G_O$; a volume flow rate of a gas selected from the group consisting of fluorine gas and fluorine-based compound gases is designated $G_{FO}$; a volume flow rate of a gas selected from the group consisting of nitrogen gas and nitrogen-based compound gases is designated as $G_{NO}$; and a volume flow ratio $X_{FO}$ is defined by $X_{FO} = G_{FO}/G_O$, and a volume flow ratio $Y_{NO}$ is defined by $Y_{NO} = G_{NO}/G_O$,

(6) a dry-etching method for a metal oxide/photoresist film laminate as described in the above item (5), wherein a range in which $Z_{FNO}$ satisfy is prescribed by an equation (8):

$$0.05 \leqq Z_{FNO} \leqq 3.0 \tag{8}$$

wherein a volume flow rate of oxygen gas is designated as $G_O$; a volume flow rate of a gas selected from the group consisting of fluorine·nitrogen-based compound gases is designated as $G_{FNO}$; and a volume flow ratio $Z_{FNO}$ is defined by $Z_{FNO} = G_{FNO}/G_O$,

(7) a dry-etching method for a metal oxide/photoresist film laminate as described in the above item (1) in which a metal oxide film is processed by dry etching with a gas containing hydrogen iodide as described above and then a photoresist film is removed with plasma of a gas containing oxygen at a pressure ranging from 0.1 to 1000 Pa, wherein said photoresist film is exposed to palsma of oxygen gas at a pressure ranging from 0.1 to 1000 Pa after the dry etching of said metal oxide film has been carried out, and then said photoresist film is removed with plasma of a gas containing oxygen as described in any of the above item (4) to (6),

(8) a dry etching method for a metal oxide/photoresist film laminate as described in the above item (1) or (4) in which plasma is produced at a pressure ranging from 0.1 to 50 Pa in a dry etching chamber after the metal oxide/ photoresist film laminate has been taken out from the dry etching chamber, wherein said plasma is produced by using at least one gas selected from the group consisting of a group consisting of fluorine gas and fluorine-based compound gases and a group consisting of nitrogen gas and nitrogen-based compound gases,

(9) a dry etching method for a metal oxide/photoresist film laminate as described in the above item (1), wherein the surface of the inside of a dry etching chamber is maintained at a temperature ranging from 60 °C or higher to 300 °C or lower,

(10) a dry etching method for a metal oxide/photoresist film laminate as described in the above item (1), wherein a gas containing hydrogen iodide contains at least one gas selected from the group consisting of helium, neon, argon, krypton, xenon and hydrogen,

(11) a dry etching method for a metal oxide/photoresist film laminate as described in the above item (1) or (4), wherein said metal oxide film is any of ITO (indium-tin-oxide), tin oxide and zinc oxide.

The present invention has made it possible to carry out uninterruptedly dry etching processing of a metal oxide film represented by ITO film by inhibiting a non-volatile substance from being produced in an apparatus in dry etching of a metal oxide film or removing it, which has been difficult to do. Further, it became possible to remove uninterruptedly a photoresist in the same apparatus.

Embodiments of the invention are described below, by way of example only, and with reference to the accompanying drawings of which:-

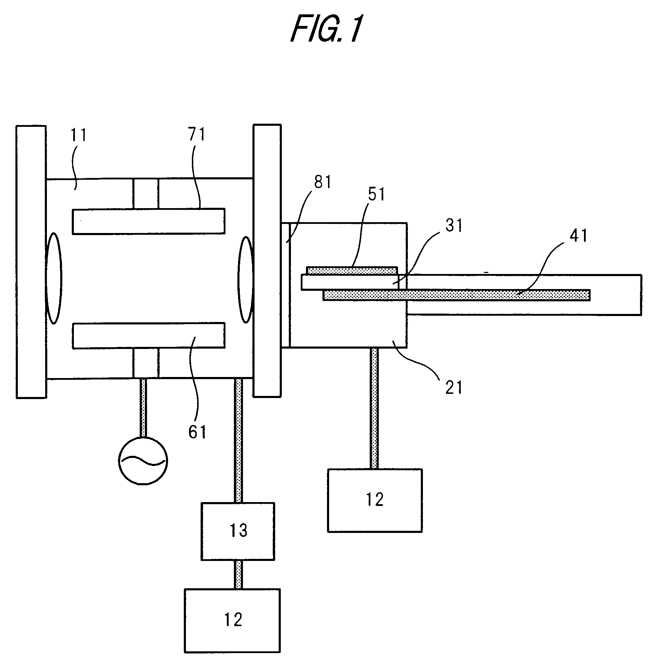

Fig. 1 shows an experimental system used in the present invention, wherein a part surrounded by dotted lines is an area where a non-volatile substance sticks.

In Fig. 1, 11 is an etching chamber, 12 is a rotary pump, 13 is a turbo-molecular pump, 21 is a loading chamber, 31 is a substrate transporting table, 41 is a substrate transprinting rod, 51 is a substrate, 61 is a high-frequency power electrode, 71 is a high-frequency grounding electrode and 81 is a gate valve.

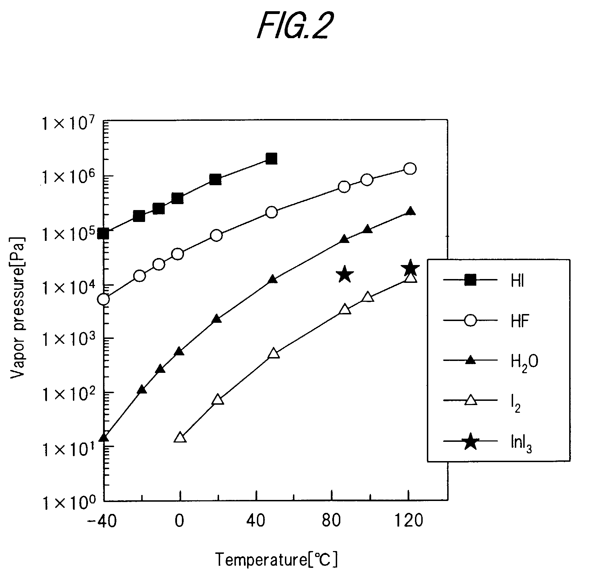

Fig. 2 shows vapor pressure curves of hydrogen iodide gas (HI), hydrogen fluoride gas (HF), iodine gas ($I_2$) and water ($H_2O$), and vapor pressure data of $InI_3$.

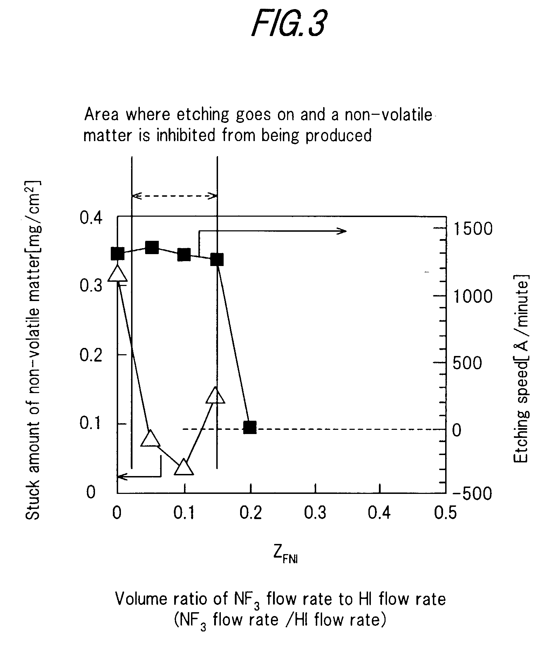

Fig. 3 is a drawing in which the etching speeds of ITO and the amounts of non-volatile substances produced are plotted against the feed ratio of nitrogen trifluoride gas to hydrogen iodide gas.

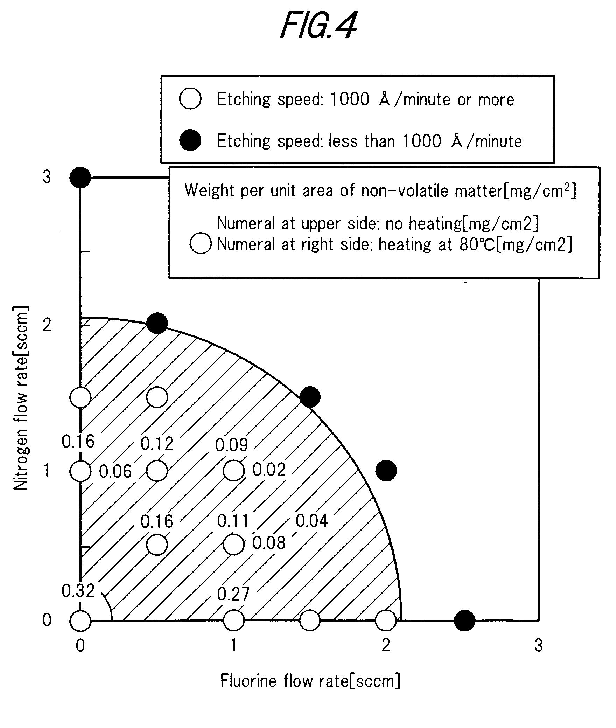

Fig. 4 shows the measured data of the etching speeds and the stuck amount of the non-volatile substances when the flow rate of hydrogen iodide gas is fixed to 10 sccm, and nitrogen gas and fluorine gas are allowed to flow at a flow rate falling in a range of 0 to 3 sccm respectively, wherein mark O's represent points where the etching speed is maintained at 1000 Å/minute or more, and mark ●'s represent points where the etching speed is less than 1000 Å/minute; and the small numerals written above mark O's represent the stuck weight of the non-volatile substance per unit area at the points.

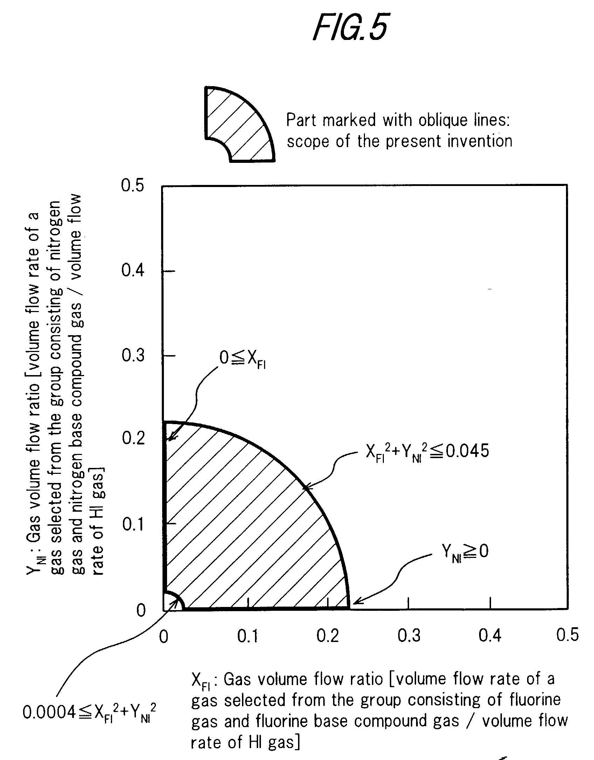

Fig. 5 shows a range in which a non-volatile substance can be inhibited from being produced without reducing the dry etching speed with a gas which contain hydrogen iodide gas, a fluorine-based gas and a nitrogen-based gas. An X axis shows a ratio of the flow rate of fluorine base gas to that of hydrogen iodide gas, and a Y axis shows a ratio of the flow rate of nitrogen base gas to that of hydrogen iodide gas, wherein a part marked with oblique lines shows an effective range in the present invention.

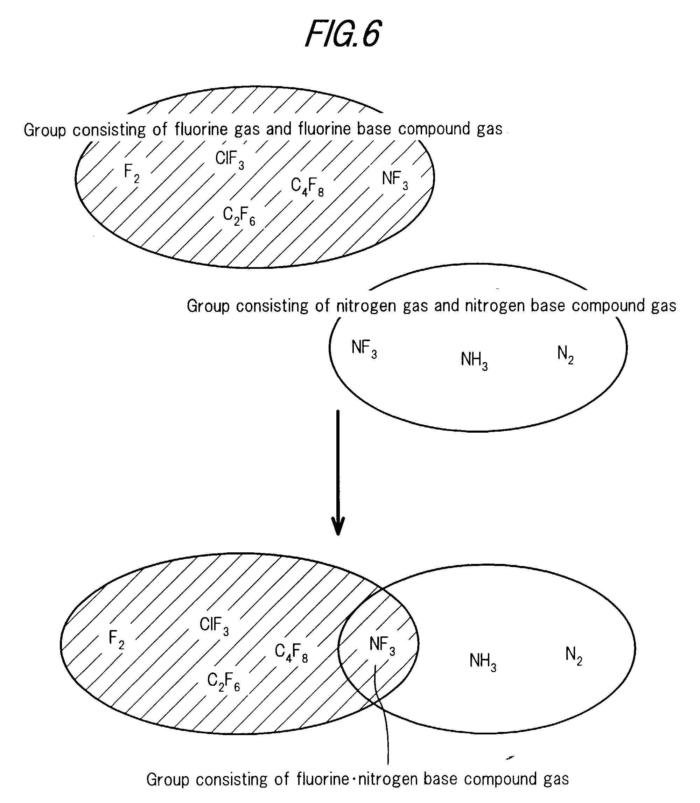

Fig. 6 is a drawing showing the relation of a gas belonging to the group consisting of fluorine gas and fluorine-based compound gases and a gas belonging to the group consisting of nitrogen gas and nitrogen-based compound gases with fluorine·nitrogen-based compound gases.

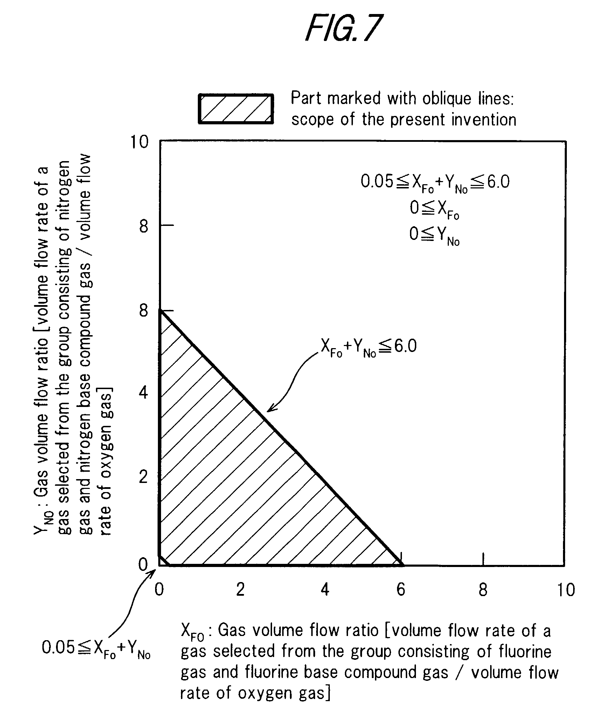

Fig. 7 is a drawing showing a range in which a photoresist film remaining after dry etching of a metal oxide in a metal oxide/photoresist film laminate with a gas which contain oxygen gas, a fluorine-based gas and a nitrogen-based gas can effectively be removed by etching. An X axis shows a ratio of the flow rate of the fluorine-based gas to that of oxygen gas, and a Y axis shows a ratio of the flow rate of the nitrogen-based gas to that of oxygen gas, wherein a part marked by oblique lines shows the range of the present invention.

An ITO film used for display electrodes of a liquid crystal display (hereinafter referred to as LCD) is formed on a substrate such as a glass plate and subjected to patterning by etching. Dry etching has been used for this patterning, and hydrogen iodide has been used as an etching gas.

An original purpose in dry etching is to process a substance subjected to etching into a desired form, and a method of making use of a photoresist is generally used for this purpose. A photoresist is coated on a metal oxide such as ITO to form a thin layer having a thickness of 10 μm or less by a method such as spin coating, and then a pattern is formed through an exposing step using visible or UV rays, a developing step and a heating/baking step to carry out etching of a substrate layer such as ITO which is a target of etching. After finishing of etching, peeling by a wet method or etching with oxygen plasma or chlorine plasma is carried out to remove a remaining photoresist. A photoresist is suitably selected in consideration of substance which is a target to be processed.

In carrying out dry etching of a metal oxide represented by ITO, a photoresist comprising a polymer is used. Performances required for this photoresist are that it can be coated evenly on a substrate which is a processing target to form a thin layer having a thickness of 10 μm or less and that it has a characteristic capable of drastically changing its bonding state with ease by radiation with light or X-rays. Further, an unnecessary part has to be readily removed by means of such as developing. Also, it is an important point to have a characteristic of enduring dry etching of a metal oxide.

When ITO that is one of the metal oxides is a processing target, a positive photoresist, for example, is used. Usually used is a photoresist comprising alkali-soluble novolak resin and a naphthoquinone diazide compound that is a sensitizer. Further, it is also one of the means to carry out processing with an acrylic photoresist. This is because they endure plasma of hydrogen iodide gas and dry etching of ITO can be carried out at a minuteness of several μm without breaking a form thereof.

A photoresist is removed by a wet method, but plasma of oxygen gas is used as a dry method using plasma in many cases. Oxygen is excited and dissociated by plasma to cut polymer chains of a photoresist, whereby volatile substances such as carbon dioxide and water are produced to remove the photoresist. In addition, there is an advantage that oxygen plasma itself is less liable to damage ITO that is a substrate layer for a photoresist.

It is observed that in carrying out dry etching with hydrogen iodide gas, a photoresist comes to have a characteristic of dry etching resistance and ITO itself has a good etching form in accordance with the intended pattern. On the other hand, it becomes difficult to remove the photoresist by etching with oxygen plasma at an after-treatment step.

This is deemed to be due to that not only etching of a photoresist itself with plasma of hydrogen iodide is not carried out but also iodine contained in hydrogen iodide sticks to the photoresist to result in providing it with a characteristic of plasma resistance. Further, it is considered that iodine itself is taken into the photoresist.

That is, it is considered that when iodine sticks to a photoresist, a substance in which iodine itself is bonded to oxygen is produced by plasma, and a part which is hard to volatilize is formed on the photoresist, so that etching is inhibited. Further, it can be estimated that when iodine is taken into a photoresist, iodine itself functions as a binder in the polymer chain and gives a characteristic of plasma resistance. This is deemed to be due to that though oxygen produces volatile carbon dioxide and water by reacting with carbon and hydrogen which constitute a polymer to oxidize its constitutional molecules, an oxygen iodide-based compound which is considered to be produced when oxygen reacts with iodine is a substance having less volatility, so that etching with oxygen is no longer effective.

Accordingly, things to be done in order to carry out dry etching of the photoresist containing iodine is to put iodine itself back to a volatile substance. Iodine molecule gas and hydrogen iodide gas are volatile, and if iodine can be changed into those substances, iodine can be removed from the photoresist. Accordingly, etching of the photoresist containing iodine becomes possible.

When dry etching of a metal oxide with hydrogen iodide is repeatedly carried out, yellow and white residual substances stick to walls and the viewing port in the apparatus. Further, if this sticking substance accumulates, the etching speed is reduced, and finally the etching stops. Accordingly, just when it is found that the residual substances are produced, it is necessary to stop the operation, open the apparatus to the atmospheric air and then wipe off the residual substances stuck to the apparatus with alcohol-based volatile chemicals.

When this residual substance is taken out and left standing in the air, it turns into a sticky liquid substance and finally becomes a transparent liquid.

This residual substance is analyzed by means of XPS (X-ray photospectroscopy), and it is confirmed that a high peak value is present in the vicinity of 446 eV, which shows the presence of trivalent indium. Further, a peak value showing the presence of monovalent indium is confirmed as well at 445 eV, but this is small.

Further, a composition thereof is analyzed by ICP (inductively coupled plasma) emission analysis to confirm peaks showing the presence of a lot of iodine (I) and of indium (In).

Non-volatile substances produced in etching of ITO with hydrogen iodide are concentrated on specific portions in the apparatus. This is as shown in Fig. 1. It is confirmed that a large part of them is produced along the circumferential part of the plasma generation portion.

In contrast with this, since non-volatile substances are not produced in portions exposed to plasma, it is considered that though a non-volatile substance has a possibility of being produced everywhere, when the non-volatile substance sticks to the portions exposed to plasma, for example, they receive the energy of electron and ion contained in the plasma and volatilizes again, so that they are prevented from sticking.

Further, since a large part of the non-volatile substance is present along the circumferential part of the plasma generation portion, it is inferred that this non-volatile substance accumulates after flying around the circumference of the plasma.

The reason why hydrogen iodide is used for etching of ITO is that indium triiodide ($InI_3$), which is deemed to be produced during etching, is a substance that has a high vapor pressure and very easily vaporizes. Accordingly, it can be deemed that stuck substances originate from $InI_3$ as well.

Investigations through literatures have resulted in finding that the Antoine equation is very effective for estimating vapor pressures, and the vapor pressures of iodine and hydrogen iodide are estimated from this equation. The results are shown in Fig. 2. The measured vapor pressure data of $InI_3$ are plotted in Fig. 2 as well.

As is apparent from the results shown in Fig. 2, iodine has considerably low vapor pressures. Accordingly, it can be considered that iodine itself becomes a binder for volatile substances such as $InI_3$ and reduces markedly their vapor pressures to produce non-volatile substances.

From the results described above, the present inventors have considered that this non-volatile substance is a substance comprising mainly $InI_3$ and it is away from a strong influence exerted by plasma to be polymerized with water ($H_2O$), iodine and iodine-based radicals and hence to increase in its apparent molecular weight.

The reason for this is deemed to be the following mechanism in dry etching of ITO with hydrogen iodide. That is, dry etching per se is a chemical reaction between ITO and hydrogen iodide making use of plasma, and therefore a chemical equation in this etching is as follows:

$$In_2O_3 + 6HI \rightarrow 2InI_3 + 3H_2O$$

This is a case in which tin itself is considered to be an impurity in ITO and the reaction is considered on the basis of indium. Two moles of $InI_3$ and 3 moles of $H_2O$ are produced from one mole of ITO. Both $InI_3$ and $H_2O$ are substances having high vapor pressures and therefore easily volatilize and come present in plasma in large quantities.

Meanwhile, the same consideration can be applied to tin, and the following chemical equation can be given:

$$SnO_3 + 4HI \rightarrow SnI_4 + 2H_2O + 0.5O_2$$

Further, hydrogen iodide itself, iodine radicals and iodine ions which are produced by dissociation of hydrogen iodide are present as well in large quantities.

$InI_3$ which is a volatile substance produced by dry etching is present in plasma. However, this $InI_3$ has such a pretty large molecular weight as 495.4 (Indium has an atomic weight of 114.8, and iodine has an atomic weight of 126.9). The reason why $InI_3$ having such a large molecular weight has a high vapor pressure is that this compound has a relatively low polarity and is not likely to form an association state between $InI_3$ molecules.

Iodine radicals produced by dissociation of hydrogen iodide, iodine molecules produced after the dissociation and $H_2O$ are present in plasma, and $InI_3$ itself receives the energy of the plasma. To be concrete, it passes through collisions with electrons and ions or collisions with radicals. It can absorb a lot of energy in the plasma and therefore does not lose its volatility. However, it is considered that if it is only a little away from the plasma, it forms an association state based on the intermolecular force with substances such as $H_2O$, iodine molecules and iodine-based ions and radicals to become a further larger compound and eventually it loses its volatility to stick to the wall of the apparatus as a non-volatile substance.

Accordingly, if a chemical substance required for preventing this association state from being formed is fed such that $InI_3$ can be discharged to the outside of the apparatus without causing association, non-volatile substances can be prevented from being produced without hindering the intended dry etching of ITO from going on.

That is, $InI_3$ floating as a substance having a high vapor pressure in the circumference of plasma bonds by virtue of a weak intermolecular force to iodine-based radicals, iodide molecules and $H_2O$ molecules each of which floats similarly and these substances act as a binder to produce a non-volatile substance comprising mainly $InI_3$. Accordingly, if this binder is separated from $InI_3$, the non-volatile substance can be prevented from being produced. In this regard, the present inventors found that some specific reactive gases were effective.

A typical substance which prevents an association state is, for example, a fluorine-based compound. Preferred are nitrogen trifluoride ($NF_3$) and chlorine trifluoride ($ClF_3$), which have a high capability to produce many fluorine radicals in plasma. The reason why these nitrogen trifluoride ($NF_3$) and chlorine trifluoride ($ClF_3$) are effective for removing, that is, vaporizing again non-volatile substances is that they can reduce intermolecular forces of substances which remain in an association state to lose volatility and bring them back again to highly volatile substances such as $InI_3$, iodine and $H_2O$.

The present inventors considered that if these fluorine-based compound gases are mixed with hydrogen iodide gas to carry out similarly dry etching with plasma, dry etching of ITO might go on without producing non-volatile substances. Then, nitrogen trifluoride of almost the same amount as that of hydrogen iodide was used as the fluorine-based compound gas to carry out etching of ITO. As a result, not only non-volatile substances were certainly inhibited from being produced but also dry etching of ITO stopped.

This can be inferred as follows. Ions and radicals produced from hydrogen iodide, which is effective for allowing dry etching of ITO with plasma to go on, cause competitive reactions with ions and radicals produced by dissociation of these fluorine-based compounds. It is considered that this has prevented hydrogen iodide gas from dissociating in a vapor phase and resulted in providing no active species sufficient for causing the reaction required for dry etching of ITO.

Taking this result into consideration, the present inventors continued intensive investigations into the conditions under which a non-volatile substance could be prevented from being produced. As a result, it was found that a non-volatile substance could be prevented from being produced under a certain condition without inhibiting dry etching of ITO from going on.

The presence of fluorine-based radicals given by a fluorine-based compound gas is presumed to relate closely to an etching speed of ITO. A reactive gas selected as the fluorine-based compound gas, an amount of which has a capability to produce fluorine-based radicals in a range of one time to a certain number of times of an equivalent of the indium element produced by etching is used in a mixture with a gas containing hydrogen iodide gas.

If the amount of these fluorine-based radicals produced is smaller than one time of the equivalent of the indium element produced by etching, an association state can not sufficiently be prevented from being formed to produce a non-volatile substance. Also, in a range in which the amount of radicals produced by excitation and dissociation of this reactive gas exceeds a certain number of times of the equivalent of the indium element, the above radical amount is in excess to prevent dry etching of ITO.

As a matter of fact, however, it is difficult to restrict the amount of the fluorine-based radicals by its ratio to the equivalent of the indium element produced by etching. The reason for this is that after an exposing area of ITO to be subjected to etching is prescribed, the required amount of the fluorine-based radicals has to be determined and this is accompanied with complicated factors in operation. In addition, a large part of the surface of ITO in etching is coated with a photoresist and therefore the exposing area of ITO is small.

Accordingly, the amount of the reactive gas is experimentally determined by the amount of hydrogen iodide gas fed. In this case, attention is paid to the presence of iodine.

That is, an amount of the gas for inhibiting a non-volatile substance from being produced without controlling etching of ITO in a practical range is experimentally determined.

With respect to a gas to be selected as the reactive gas, nitrogen trifluoride ($NF_3$), chlorine trifluoride ($ClF_3$) and sulfur hexafluoride ($SF_6$) are preferably selected as substances producing fluorine-based radicals.

The etching method of the present invention including an apparatus used in the present invention shall specifically be explained below. An apparatus used for etching is shown in Fig. 1. The apparatus used in the present invention is of a load lock system, and etching can be advanced without exposing the main frame of etching chamber 11 to the air by taking in and out a substrate from loading chamber 21. Substrate 51 is placed on power electrode 61. Shown in Fig. 1 is an apparatus using high-frequency parallel plate capacitance-coupling type discharge electrodes called RIE. However, the present invention shall not be restricted to this apparatus.

In Fig. 1, shown by enclosing with dotted lines are places where non-volatile substances produced are liable to stick when dry etching of ITO is carried out by a method not based on the present invention.

Results obtained by carrying out dry etching with this gas providing fluorine-based radicals and fluorine-based ions are explained in the examples described later. Shown in Fig. 3 are results obtained by studying changes in the etching speed and changes in the weight of a test piece placed in the etching apparatus when a mixed gas of nitrogen trifluoride ($NF_3$) and hydrogen iodide is used and the mixing ratio is changed optionally. It is apparent from the results shown in Fig. 3 that there is a proper quantity in the ratio of nitrogen trifluoride mixed with hydrogen iodide and that when the amount of nitrogen trifluoride is smaller than this proper quantity, a lot of non-volatile substances stick though dry etching goes on. Further, it is observed that when the amount of nitrogen trifluoride is larger than this proper quantity, the non-volatile substances are inhibited from being produced but dry etching is inhibited as well from going on.

It has been found from the results shown in Fig. 3 that in order to inhibit the non-volatile substances from being produced without preventing etching of ITO in a practical range, it is desirable to set the feed ratio of nitrogen trifluoride to hydrogen iodide to a range from 0.02 or more to 0.15 or less.

The results obtained shall be explained in more details. When etching was carried out under a condition that nitrogen trifluoride was not fed while the feed amount of hydrogen iodide was maintained at 10 sccm (standard $cm^3$/m), the etching speed was 1300 Å/minute. In contrast with this, the etching speed was almost 1300 Å/minute when the feed ratio of nitrogen trifluoride to hydrogen iodide was set to 0.1, and when the feed ratio was 0.15 or less, the high etching speed exceeding 1000 Å/minute could be maintained while the etching speed was reduced to some extent.

Then, considered again was why a marked effect could be confirmed when using nitrogen trifluoride gas that is a fluorine-based compound gas to be effective as the reactive gas. The nitrogen trifluoride gas is characterized in that it contains a nitrogen atom as well as fluorine atoms. It is estimated from the fact that not only a fluorine radical is effective but also a cooperative action of a nitrogen atom as a radical or an ion with a fluorine-based radical may bring about a large effect on inhibiting a non-volatile substance from being produced.

Then, a mixture of fluorine gas and nitrogen gas was allowed to flow together with hydrogen iodide gas to be used for etching of ITO to confirm an effect on inhibiting a non-volatile substance from being produced, and it was confirmed that a large effect was brought about on inhibition of the production of a non-volatile substance.

In Fig. 1, enclosed with dotted lines are places where non-volatile substances produced when dry etching of ITO is allowed to go on only with hydrogen iodide gas are liable to stick. Test pieces were placed at the places for the purpose of collecting the non-volatile substances, and a glass substrate on which ITO was formed in a thick layer was placed on the power electrode. Then, dry etching was carried out with a gas obtained by mixing hydrogen iodide gas with fluorine gas and nitrogen gas, and the etching speeds of ITO and the amounts of the non-volatile substances stuck to the test pieces were actually plotted to thereby obtain Fig. 4.

In the present invention, in addition to the fluorine gas and the nitrogen gas described above, fluorine-based compound gases, nitrogen-based compound gases and gases containing both fluorine element and nitrogen element in a molecular structure (fluorine· nitrogen-based compound gases) can be used as well.

As the first reactive gas, a gas containing these gases and hydrogen iodide is defined as:

(a) a gas containing hydrogen iodide gas and at least one gas selected from the group consisting of a group consisting of fluorine gas and fluorine-based compound gases and a group consisting of nitrogen gas and nitrogen-based compound gases, or

(b) a gas containing hydrogen iodide gas and at least one gas of gases containing both fluorine element and nitrogen element in its chemical structure (fluorine· nitrogen-based compound gas).

Flowing conditions of the gas for the purpose of carrying out dry etching of ITO with inhibiting non-volatile substances from being produced are obtained from the results shown in Fig. 4.

A range satisfied by $X_{FI}$ and $Y_{NI}$ is prescribed by equations (1), (2) and (3):

$$0.0004 \leqq X_{FI}{}^2 + Y_{NI}{}^2 \leqq 0.045 \tag{1}$$

$$X_{FI} \geqq 0 \tag{2}$$

$$Y_{NI} \geqq 0 \tag{3}$$

wherein a volume flow rate of hydrogen iodide gas is designated as $G_{HI}$; a volume flow rate of a gas selected from the group consisting of fluorine gas and fluorine-based compound gases is designated as $G_{FI}$; a volume flow rate of a gas selected from the group consisting of nitrogen gas and nitrogen-based compound gases is designated as $G_{NI}$; and volume flow ratios $X_{FI}$ and $Y_{NI}$ are defined by $X_{FI} = G_{FI}/G_{HI}$ and $Y_{NI} = G_{NI}/G_{HI}$, respectively. This range is distinctly shown in Fig. 5.

Next, in the case of fluorine·nitrogen-based compound gas, a range satisfied by $Z_{FNI}$ is prescribed by equation (4):

$$0.02 \leqq Z_{FNI} \leqq 0.15 \tag{4}$$

wherein a volume flow rate of hydrogen iodide gas is designated as $G_{HI}$; a volume flow rate of a gas selected from the group consisting of fluorine·nitrogen-based compound gases is designated as $G_{FNI}$; and volume flow ratio $Z_{FNI}$ is defined by $Z_{FNI} = G_{FNI}/G_{HI}$.

In the above description, attention has to be paid to that the fluorine·nitrogen-based compound gases belong to the group consisting of fluorine gas and fluorine-based compound gases as well as the group consisting of nitrogen gas and nitrogen-based compound gases.

In the present invention, the gas belonging to the group consisting of fluorine gas and fluorine-based compound gases includes fluorine gas, nitrogen trifluoride gas, chlorine trifluoride gas, sulfur hexafluoride gas, ethane hexafluoride gas and tetracarbon octafluoride gas. The group consisting of nitrogen gas and nitrogen-based compound gases includes nitrogen gas, ammonia gas, dinitrogen oxide gas and nitrogen trifluoride gas. The nitrogen trifluoride gas is a fluorine·nitrogen-based compound gas and belongs to the group consisting of fluorine gas and fluorine-based compound gases as well as the group consisting of nitrogen gas and nitrogen-based compound gases. This relation is specifically shown in Fig. 6. In this drawing, nitrogen trifluoride gas belongs to the overlapped part of two aggregations.

Accordingly, the fluorine·nitrogen-based compound gases are included in $G_{FI}$ as well as $G_{NI}$ in equations 1 to 3, so that it applies to both volume flow ratios $X_{FI}$ and $Y_{NI}$ and is a gas which should doubly be calculated.

To explain this in detail, the volume flow ratio $Z_{FNI}$ of the fluorine·nitrogen-based compound gas to hydrogen iodide gas is prescribed by equation (4):

$$0.02 \leqq Z_{FNI} \leqq 0.15 \tag{4}$$

and corresponds to $X_{FI}$ and $Y_{NI}$ in equation (1):

$$0.0004 \leqq X_{FI}{}^2 + Y_{NI}{}^2 \leqq 0.045 \tag{1}$$

That is,

$$Z_{FNI} = X_{FI}$$

and

$$Z_{FNI} = Y_{NI}$$

Accordingly, in the case of the upper limit of the equation (1), a value of $Z_{FNI} = 0.15$ is substituted for $X_{FI}$ and $Y_{NI}$ in equation (1), and then

$$Z_{FNI}{}^2 + Z_{FNI}{}^2 = 0.15^2 + 0.15^2 = 0.045$$

Thus, it can be found that the equations are effective without any inconsistency.

Similarly, in the case of the lower limit in the equation (1), a value of $Z_{FNI} = 0.02$ is substituted for $X_{FI}$ and $Y_{NI}$ in equation (1), and then

$$Z_{FNI}{}^2 + Z_{FNI}{}^2 = 0.02^2 + 0.02^2 = 0.0008$$

and the value thus obtained is in the range of the equation (1).

Accordingly, it is understood that fluorine· nitrogen-based compound gas represented by nitrogen trifluoride gas for which equation (4) is satisfied satisfies equation (1) at the same time.

Next, considering that heating the wall of an etching chamber might be able to raise the volatility, a heater was placed in an etching chamber and maintained at 85°C, and then inspection of the state of a non-volatile substance sticking to the heater portion results in finding a range in which the non-volatile substance was drastically reduced.

Then, the range was minutely confirmed by experiments, and as a result, etching processing could be carried out while the production of a non-volatile substance is controlled without preventing etching of ITO by heating the wall of the apparatus under the condition that a flow rate of a fluorine-based gas to a flow rate of hydrogen iodide gas is 0.02 to 0.22 in terms of a volume flow ratio.

However, when the flow rate of a fluorine-based gas to the flow rate of hydrogen iodide gas is smaller than 0.02 in terms of a volume flow ratio, the fluorine-based gas provides a small effect on inhibition of producing a non-volatile substance. Though etching goes on in this range, a non-volatile substance cannot be inhibited from being produced. Further, when the flow rate of fluorine gas to the flow rate of hydrogen iodide gas is larger than 0.22 in terms of a volume flow ratio, the fluorine-based gas provides a large effect on inhibition of producing the non-volatile substances. However, etching is inhibited. In other words, while a non-volatile substance is hard to produce in this range, the etching stops. Accordingly, the flow rate of fluorine-based gas to the flow rate of hydrogen iodide gas is suitably in a range of 0.02 to 0.22 in terms of a volume flow ratio. In this case, however, the wall of the apparatus is preferably heated.

A heating condition for accelerating inhibition of producing a non-volatile substance is as follows. That is, a function to elevate an inside surface temperature of the apparatus to 60°C or higher is preferably provided. In particular, heating to 100°C or higher is effective for vaporizing $InI_3$ and iodine molecules which are main constitutional substances of a non-volatile substance.

However, heating to 300°C or higher is not preferred. This is because heating to 300°C or higher reduces trivalent $InI_3$ by heat energy and converts it to monovalent $InI$ having a low vapor pressure.

It is preferred to provide a function to elevate the inside surface temperature of the apparatus to 60°C or higher and carry out etching under a condition that the surface is not heated to 300°C or higher.

As described above, it is observed that when dry etching is carried out with hydrogen iodide gas, a photoresist has a dry etching resistance, and ITO itself has a good etching form in accordance with the designed pattern. On the other hand, it becomes difficult to remove a photoresist by etching with oxygen plasma at an after-treating step.

This is deemed to be attributable to that etching of the photoresist itself can not be carried out with plasma of hydrogen iodide and that iodine contained in hydrogen iodide sticks to the photoresist, so that it is provided with plasma resistance. Further, it is considered that iodine itself is taken into the photoresist.

Gas capable of turning iodine back again to a volatile substance includes fluorine gas and fluorine-based compound gases (fluorine-based gases), nitrogen gas and nitrogen-based compound gases (nitrogen-based gases), and fluorine·nitrogen-based compound gases.

Then, the present inventors found that a second reactive gas containing oxygen as well as the gas described above is very excellent for removing a photoresist containing iodine molecules.

That is, the second reactive gas containing oxygen gas comprises:

(a) a gas containing oxygen gas and at least one gas selected from the group consisting of a group consisting of fluorine gas and fluorine-based compound gases and a group consisting of nitrogen gas and nitrogen-based compound gases, or

(b) a gas containing oxygen gas and fluorine·nitrogen-based compound gases.

A mixing ratio of the gas corresponding to (a) to oxygen gas is as follows.

The volume flow rate of oxygen gas in the second reactive gas containing oxygen is designated as $G_O$; and the volume flow rate of the gas selected from the group consisting of fluorine gas and fluorine-based compound gases is designated as $G_{FO}$, and the volume flow rate of the gas selected from the group consisting of nitrogen gas and nitrogen-based compound gases is designated as $G_{NO}$. Volume flow ratios $X_{FO}$ and $Y_{NO}$ are defined by $X_{FO} = G_{FO}/G_O$ and $Y_{NO} = G_{NO}/G_O$, respectively. Then, a range satisfied by $X_{FO}$ and $Y_{NO}$ is prescribed by:
equation (5)

$$0.05 \leqq X_{FO} + Y_{NO} \leqq 6.0 \tag{5}$$

equation (6)

$$X_{FO} \geqq 0 \tag{6}$$

and equation (7)

$$Y_{NO} \geqq 0 \tag{7}$$

This range is shown in Fig. 7.

Further, a mixing ratio of the gas corresponding to (b) to oxygen gas is as follows.

The volume flow rate of oxygen gas in the second reactive gas containing oxygen is designated as $G_O$, and the volume flow rate of the fluorine·nitrogen-based compound gas is designated as $G_{FNO}$. Volume flow ratio $Z_{FNO}$ is defined by:

$$Z_{FNO} = G_{FNO}/G_O$$

Then, a range satisfied by $Z_{FNO}$ is preferably prescribed by equation (8):

$$0.05 \leqq Z_{FNO} \leqq 3.0 \tag{8}$$

Attention has to be paid to the same, as stated in the item of the first reactive gas. The fluorine·nitrogen-based compound gas contained in the second reactive gas is a gas belonging to both of the gas selected from the group consisting fluorine gas and fluorine-based compound gases and the gas selected from the group consisting nitrogen gas and nitrogen-based compound gases. If calculation is carried out based on $X_{FO} = Z_{FNO}$ and $Y_{NO} = Z_{FNO}$ in equation 5, the upper and lower limits of equation 8 are adapted to those of equation 5.

Oxygen is required to cut bonds of a polymer to form volatile gas. However, when an amount of oxygen gas is more than the limit of the present invention while containing the reactive gas, the cutting of the bonds of the polymer can readily be done but iodine itself can not volatilize, so that dry etching of a photoresist can not be allowed to effectively go on. In contrast with this, when an amount of oxygen gas is less than the limit of the present invention, the polymer chain itself can not be cut, so that dry etching of the polymer does not effectively go on in this case either.

Also, when the substrate itself is heated to 250°C or lower, the removing of a polymer by etching can be allowed to effectively go on. The substrate itself is heated preferably from 60°C or higher to 200°C or lower, more preferably from 80°C or higher to 150°C or lower. In general, a photoresist has a heat resistant temperature of about 150°C but if iodine is taken thereinto with iodine plasma, it has a property to endure higher temperatures.

Since a photoresist containing iodine has etching resistance, it becomes a very preferred photoresist material from a viewpoint of pattern formation. That is, the photoresist film thinner than conventional ones can sufficiently play its role and can sufficiently function to form its patterning.

Accordingly, etching which is advantageous in terms of productivity can be carried out by making a photoresist polymer film itself thinner to make up for a reduction in the etching speed that is caused by iodine contained therein, the photoresist-removing speed.

Then, found as a method by which etching is advanced while making the best use of this advantageous point on processing was a method in which dry etching with plasma of hydrogen iodide gas is carried out for etching a metal oxide coated thereon with good etching being possible without destroying the shape of the photoresist and the photoresist is removed by a dry method using plasma without resorting a wet method and further in which dry etching can be carried out while a non-volatile substance produced during dry etching is reduced to the utmost at any place of a dry etching chamber.

One aspect of the present invention is to mix hydrogen iodide with a gas containing at least one gas selected from the group consisting of a group consisting of fluorine and fluorine-based compound gases and a group consisting of nitrogen and nitrogen-based compound gases to prepare the first reactive gas which is used at a first dry etching step of a metal oxide to thereby make it possible to reduce the production of a non-volatile substance to the utmost and then to similarly mix oxygen with a gas containing at least one gas selected from the group consisting of a group consisting of fluorine and fluorine-based compound gases and a group consisting of nitrogen and nitrogen-based compound gases to prepare the second reactive gas which is used for removing a photoresist film at the second dry etching step.

Further, it has been found that as a method for removing efficiently a photoresist containing iodine after carrying out the first step of dry etching of a metal oxide with the first reactive gas, the metal oxide/photoresist film laminate is once exposed to plasma of oxygen gas and then the photoresist film is removed with the second reactive gas containing oxygen at the second etching step, whereby etching processing of the metal oxide/photoresist film laminate becomes possible at higher speed. This method is also included in the present invention.

The first etching gas is used for inhibiting a non-volatile substance to the utmost from being produced in dry etching with a gas comprising mainly hydrogen iodide. The second reactive gas is used for making it easy to remove a photoresist into which iodine is taken or in which iodine sticks on a surface by etching with oxygen plasma. The step of exposing to oxygen plasma, which is interposed between the first dry etching step and the second dry etching step, becomes very effective for finishing more quickly the second dry etching step.

Though these two reactive gases have almost the similar constituents, their roles seem to be contradictory to each other. The role of the first reactive gas resides in the inhibition of production of a non-volatile substance polymerized with an iodine element being a binder and advances good etching without non-volatile substances. On the other hand, the second reactive gas has a role to accelerate an action of etching of a photoresist so as to volatilize iodine against the action of inhibiting a polymer photoresist from being decomposed into volatile components with iodine taken in as a binder at the first step.

A test for removing a photoresist by etching shall be explained. An acrylic resin and an acrylic monomer were used for a photoresist and coated on an ITO film. Then, it was subjected to irradiation with UV rays, developing treatment and solidification by heating and baking in the pattern form according to conventional methods, and then etching with oxygen plasma was tried. An etching speed exceeding 2000 Å/minute under a pressure condition of about 13 Pa was obtained, and a satisfactory performance was shown.

Next, in order to confirm an effect of hydrogen iodide plasma, a photoresist film was formed on an ITO film and then exposed to plasma of hydrogen iodide to remove ITO and then etching was carried out with oxygen to find that the etching speed was reduced sharply and was as much slow as less than 100 Å/minute.

Then, nitrogen trifluoride as fluorine·nitrogen-based compound gas was mixed as a reactive gas with oxygen gas to thereby confirm an etching effect on a photoresist film. The photoresist film used here was the one after subjecting to dry etching by exposing to plasma of a gas containing mainly hydrogen iodide. A mixing ratio of nitrogen trifluoride as the reactive gas to oxygen gas is 1 : 2, that is, volume flow ratio $Z_{FNO}$ of nitrogen trifluoride gas to oxygen gas in the second reactive gas containing oxygen gas is 0.5.

An etching speed of about 700 Å/minute for the photoresist film was obtained, and therefore etching of the photoresist containing iodine at high speed, which had not been achieved by plasma etching only with oxygen, became possible.

Further, in order to remove more quickly a photoresist film by dry etching after dry etching of ITO with a gas containing hydrogen iodide, the photoresist film was first exposed to plasma of oxygen and then subjected to etching with a gas obtained by mixing oxygen gas with nitrogen trifluoride as a reactive gas. Also in this case, volume flow ratio $Z_{FNO}$ of nitrogen trifluoride gas to oxygen gas in the second reactive gas is 0.5. In etching of the photoresist film exposed to hydrogen iodide plasma with the second reactive gas containing oxygen gas, an etching speed exceeding 1000 Å/minute could be obtained.

In this case, if a photoresist is exposed in advance to oxygen plasma, a small amount of the non-volatile substance sticking to the wall of an etching chamber turns into a substance having higher non-volatility by oxygen plasma to thereby be stabilized, and as a result, it is prevented from sticking again to the photoresist.

Accordingly, in carrying out dry etching of a metal oxide comprising mainly ITO/photoresist film laminate, provided are the first step of carrying out dry etching of a metal oxide with plasma of the first reactive gas containing hydrogen iodide and the second step of removing a photoresist by etching with plasma of the second reactive gas containing oxygen gas, and further a step of exposing to plasma of oxygen gas is interposed between the first step and the second step, whereby dry etching of the metal oxide/photoresist laminate can be carried out at high speed.

The reactive gases used at the first step and the second step have to satisfy the flow conditions described above (equations 1 to 8).

A suitable gas as the reactive gas of the present invention includes nitrogen trifluoride as a fluorine·nitrogen-based compound gas. Fluorine-based gases include fluorine, chlorine trifluoride, sulfur hexafluoride, ethane hexafluoride and tetracarbon. Nitrogen-based gases include nitrogen, ammonia, hydrazine, dinitrogen oxide and nitrogen monoxide.

A pressure condition suitable for carrying out dry etching of ITO with hydrogen iodide is in a range of 0.1 Pa to 100 Pa, more preferably 0.5 Pa to 20 Pa. When the pressure is lower than the lower limit a gas itself is mainly exhausted, and the amount of gas sufficient for forming discharge with parallel plate type discharge electrodes based on RIE can not be maintained in the apparatus. Further, dissociation is accelerated by plasma under the pressure condition higher than the upper limit, and as a result, the formation of a non-volatile substance is more accelerated. This results in a reduction in the dry etching speed and therefore is not a preferred state. Further, anisotropic etching which is the characteristic of RIE becomes difficult, and good dry etching characteristics can not be provided.

Further, heating of the wall and the inspection hole of a chamber used for etching brings about preferred effects as well. Etching of a photoresist is successively carried out after the finishing of etching of ITO itself, and the state that the wall of the chamber is heated from 60°C or higher to 300°C or lower is very effective as well at the etching step of a photoresist with the second reactive gas. The wall of the chamber is heated more preferably from 80°C or higher to 200°C or lower.

The method disclosed above can sufficiently inhibit a non-volatile substance from being produced without preventing etching of a metal oxide from going on in dry etching of a metal oxide/photoresist film laminate. However, the first reactive gas is effective for inhibiting dry etching of a metal oxide from going on while it is effective for inhibiting a non-volatile substance from being produced, and therefore operation in a suitable range of its amount is required. Even if this method is used, it is difficult to continue to operate dry etching while completely inhibiting a non-volatile substance from being produced. Non-volatile substances, though only a little, stick to the wall of a chamber, and necessity to remove these non-volatile substances arises during continuing operation over a long period of time.

Then, as a method for enabling to remove easily a non-volatile substance after removal of a metal oxide/photoresist film laminate, which is a target of dry etching, from a chamber, the present inventors have developed a method in which the third reactive gas is fed to the dry etching apparatus to produce plasma to thereby remove a non-volatile substance.

The third reactive gas characterized by comprising a fluorine·nitrogen-based compound gas or a gas in which fluorine-based gas and nitrogen-based gas are mixed in an optional volume proportion is used as a cleaning gas for removing a non-volatile substance in a chamber.

When it was tried to remove a non-volatile substance with nitrogen trifluoride gas as a fluorine· nitrogen-based compound gas, a very good cleaning effect could be confirmed. When nitrogen trifluoride was used after hydrogen iodide was used for dry etching of ITO for 2 hours, a non-volatile substance could be removed up to the state such that the non-volatile substance was scarcely left after 2 hours.

Either a fluorine-based gas or a nitrogen-based gas can be used alone as the third reactive gas.

However, it is more effective in terms of removing a non-volatile substance to use a mixture of fluorine-based gas and nitrogen-based gas rather than to use them alone.

A degree of removing a non-volatile substance can be confirmed by analyzing the composition of substances stuck to a test piece for allowing a non-volatile substance to stick thereto. For example, after placing an SUS plate in a dry etching chamber, a non-volatile substance produced by generating plasma of hydrogen iodide gas with ITO being placed on an electrode is collected. The composition of the collected non-volatile substance can be determined by means of AES (Auger electron spectroscopy) and ICP-ES (inductively coupled plasma emission spectroscopy).

Subsequently, while leaving the produced non-volatile substance in the dry etching chamber as it is, plasma of the third reactive gas is produced, and then the composition of the non-volatile substance stuck to the test piece is determined, whereby a change in the non-volatile substance can be confirmed.

The composition of the non-volatile substance itself comprised mainly In (indium), I (iodine) and Si (silicon). Silicon was detected because a silicon-based gas had been used in a large quantity in the dry etching chamber, but it has no relation with the present invention.

The stuck amount of the non-volatile substance could be reduced sharply by exposing this non-volatile substance to plasma of nitrogen trifluoride, which was the third reactive gas. With respect to the composition, particularly In and I could be reduced sharply. Further, Sn (tin) contained in ITO could be reduced sharply as well. However, the contents of oxygen and carbon did not change. On the other hand, a peak of fluorine which was considered to be attributable to an influence of nitrogen trifluoride was detected.

The similar tendency could be confirmed as well when fluorine gas and chlorine trifluoride gas were used.

The first reactive gas containing hydrogen iodide as the principal component may be mixed with an inert gas such as helium, neon, argon, krypton or xenon. They can collide against electrodes, particularly high-frequency-power electrodes, with positive ions and therefore can be expected to raise the etching speed of dry etching and to improve the anisotropic etching performance.

Further, the first reactive gas containing hydrogen iodide as the principal component may be mixed with hydrogen. However, it is not preferred that hydrogen gas dilutes hydrogen iodide gas to reduce dry etching performances of hydrogen iodide gas. The volume amount thereof is 10 times to hydrogen iodide gas or less.

It is one aspect of the present invention as well to perform the function of producing reactive radicals from a reactive gas with the same apparatus provided with a mechanism to produce plasma for carrying out etching. Installation of new facilities having the function of producing reactive radicals results in enforcing a load on the existing apparatus and therefore is not a preferred method. The present invention is characterized in that the function can be achieved by feeding the existing apparatus with a gas.

The etching apparatus of the present invention is characterized in that a frequency applied to high-frequency electrodes is from 1 MHz or more to 150 MHz or less, more preferably from 5 MHz or more to 80 MHz or less and most preferably from 13.56 MHz or more to 50 MHz or less. When the frequency applied to the high-frequency electrodes is raised, an amount of radicals produced increases. Accordingly, the raising of the frequency results in enabling to elevate the dry etching speed of ITO.

However, as the frequency applied to the high-frequency electrodes is elevated, the self bias voltage is reduced. As a result, an amount of positive ions colliding against a substrate is controlled, so that a phenomenon of a reduction in the dry etching speed is observed. Accordingly, the suitable frequency applied to the high-frequency electrodes is restricted.

EXAMPLES

The present invention shall more specifically be explained below with reference to examples.

Example 1

An ITO thin film substrate having a thickness of 1 µm formed by magnetron sputtering was placed on an power electrode of an apparatus equipped with capacitance-coupling type high-frequency electrodes, and vacuumizing was carried out. After obtaining a vacuum of $1 \times 10^{-2}$ Pa or less, hydrogen iodide gas and nitrogen trifluoride gas were allowed to flow to carry out dry etching. In order to calculate accurately a dry etching speed, a polyimide tape was adhered to the ITO thin film substrate, and the dry etching speed was calculated from the difference between the thicknesses observed before and after the dry etching.

| Etching conditions: | |
| --- | --- |
| Substrate | placed on power electrode side |
| Frequency | 13.56 MHz (RF) |
| RF electric power | 200 W |
| Electrode area | 78.5 cm$^2$ |
| Pressure in apparatus | 7 Pa |
| Gas flow rate | hydrogen iodide gas 10 sccm |
| | nitrogen trifluoride gas 0 to 2 sccm |
| Etching time | 5 minutes |
| Wall temperature | room temperature at the initial stage |

Dry etching was carried out for 5 minutes under the conditions described above at flow rates of nitrogen trifluoride in a range of 0 to 2 sccm to calculate the dry etching speeds. The results thereof are shown in Fig. 3.

Under a condition that nitrogen trifluoride gas was not allowed to flow, that is, when only hydrogen iodide gas was used and the flow rate of nitrogen trifluoride gas was 0 sccm, a dry etching speed of 1300 Å/minute was obtained. Next, as the flow rate of nitrogen trifluoride gas was increased while the flow rate of hydrogen iodide gas was kept fixed, the dry etching speed of ITO was reduced. However, a dry etching speed of 1300 Å/minute could be maintained at flow rates of nitrogen trifluoride gas in a range of up to 1.5 sccm. Then, the flow rate of nitrogen trifluoride gas was raised to 2 sccm, so that the dry etching speed was reduced to almost 0 Å/minute. The flow rate of nitrogen trifluoride gas was increased further more but dry etching was no longer advanced.

Example 2

The apparatus equipped with capacitance-coupling type high-frequency electrodes was used as was the case with Example 1. In Example 2, however, to make the production of a non-volatile substance and the effect of inhibiting the production clear, a glass plate was placed on a power electrode of the high-frequency electrodes, and 20 pieces of ITO pellets having a diameter of 1 cm used for an EB evaporation device were arranged so that the area of exposed parts became about 25 $cm^2$. Then, vacuumizing was carried out. After obtaining a vacuum of $1 \times 10^{-2}$ Pa or less, hydrogen iodide gas and nitrogen trifluoride gas were allowed to flow to carry out dry etching. Further, an SUS test piece was adhered to a place where a non-volatile substance would stick to an apparatus wall with a polyimide tape to carry out dry etching for a prescribed time, and then the weight was determined.

The test piece of SUS has a surface area of about 3 $cm^2$, and both ends thereof were fixed with a polyimide tape, so that the area of the exposed part was controlled to 2 $cm^2$. The test piece of SUS has a thickness of 0.3 mm.

A Sartorius-made electron balance capable of measuring up to 0.01 mg was used for determining the weight.

| Etching conditions: | |
|---|---|
| Substrate | placed on power electrode side |
| Frequency | 13.56 MHz (RF) |
| RF electric power | 200 W |
| Electrode area | 78.5 $cm^2$ |
| Pressure in apparatus | 7 Pa |
| Gas flow rate | hydrogen iodide gas 10 sccm |
| | nitrogen trifluoride gas 0 to 2 sccm |
| Etching time | 2 hours |
| Wall temperature | room temperature at the initial stage |

Dry etching was carried out for 2 hours under the conditions described above at flow rates of nitrogen trifluoride gas in a range of 0 to 3 sccm. In measuring the weights, the polyimide tape was removed, and the weights per unit area obtained by dividing the weights of a non-volatile substance by the exposed area of SUS were plotted.

Under a condition that nitrogen trifluoride gas was not allowed to flow, that is, when only hydrogen iodide gas was used and the flow rate of nitrogen trifluoride gas was 0 sccm, the weight of a non-volatile substance per unit area was 0.32 $mg/cm^2$. However, the non-volatile substance was reduced sharply by feeding nitrogen trifluoride gas at 1 sccm and could not be found with eyes. This was measured by means of an electron balance to find that it was 0.04 $mg/cm^2$. This is an almost negligible amount of the non-volatile substance produced. Further, as the feed amount of nitrogen trifluoride gas was increased, the non-volatile substance could not be found, and the weight was almost zero.

The results obtained in Example 1 and Example 2 were summarized, and the dry etching speeds of ITO and the amounts of the non-volatile substances produced were shown in Fig. 3 by plotting. The feed ratio of nitrogen trifluoride gas to hydrogen iodide gas is marked on the axis of abscissa. It could be found from this Fig. 3 that the combination of hydrogen iodide gas and nitrogen trifluoride gas accelerated etching of ITO but a range effective for inhibiting the non-volatile substance to the utmost from being produced was present. It could be confirmed that the above range was 0.02 to 0.15.

Example 3

As was the case with Example 1 and Example 2, an ITO thin film substrate having a thickness of 1.5 μm formed by magnetron sputtering was placed on a power electrode of an apparatus equipped with capacitance-coupling type high-frequency electrodes, and then vacuumizing was carried out. After obtaining a vacuum of $1 \times 10^{-2}$ Pa or less, hydrogen iodide gas, nitrogen gas and fluorine gas were allowed to flow to carry out dry etching. In order to calculate accurately the dry etching speed, a polyimide tape was adhered to the ITO thin film substrate, and the dry etching speed was calculated from the difference between the thicknesses observed before and after the dry etching.

| Etching conditions: | |
|---|---|
| Substrate | placed on power electrode side |
| Frequency | 13.56 MHz (RF) |
| RF electric power | 200 W |
| Electrode area | 78.5 $cm^2$ |
| Pressure in apparatus | 7 Pa |
| Gas flow rate | hydrogen iodide gas 10 sccm |

(continued)

| Etching conditions: | |
|---|---|
| | nitrogen gas 0 to 3 sccm |
| | fluorine gas 0 to 2.5 sccm |
| Etching time | 10 minutes |
| Wall temperature | room temperature at the initial stage |

A dry etching speed of 1300 Å/minute was obtained under a condition that only hydrogen iodide gas was allowed to flow. Further, the flow rates of nitrogen gas and fluorine gas were changed while the flow rate of hydrogen iodide gas was kept fixed to determine the respective dry etching speeds. The results of the etching speeds thus obtained are shown in Fig. 4, wherein a point having a dry etching speed of 1000 Å/minute or more is marked with ○, and a point having a dry etching speed of less than 1000 Å/minute is marked with ●. As a result, it could be confirmed that points where as the nitrogen gas flow rate and the fluorine gas flow rate increased, the dry etching speed was reduced, were present distinctly.

Simply showing these points, etching speeds of 1000 Å/minute or more could be confirmed in a range shown by:

$$(\text{nitrogen flow rate})^2 + (\text{fluorine flow rate})^2 \leqq 4.5 \text{ sccm}^2$$

Example 4

The apparatus equipped with capacitance-coupling type high-frequency electrodes was used as was the case with Example 3. In Example 4, however, in order to make production of a non-volatile substance and the effect of inhibiting the production clear, a glass plate was placed on a power electrode of the high-frequency electrodes, and 20 pieces of ITO pellets having a diameter of 1 cm used for an EB evaporation device were arranged so that the area of exposed parts including side areas became about 25 cm$^2$. Then, vacuumizing was carried out. After obtaining a vacuum of $1 \times 10^{-2}$ Pa or less, hydrogen iodide gas, nitrogen gas and fluorine gas were allowed to flow to carry out dry etching under the following conditions. Further, an SUS test piece was adhered to a place where a non-volatile substance would stick to an apparatus wall with a polyimide tape to carry out dry etching for a prescribed time, and then the weight was determined.

The test piece of SUS has a surface area of 3 cm$^2$, and both ends thereof were fixed with a polyimide tape, so that the area of the exposed part was controlled to 2 cm$^2$. The test piece of SUS has a thickness of 0.3 mm.

The Sartorius-made electron balance capable of measuring up to 0.01 mg was used for determining the weight.

| Etching conditions: | |
|---|---|
| Substrate | placed on power electrode side |
| Frequency | 13.56 MHz (RF) |
| RF electric power | 200 W |
| Electrode area | 78.5 cm$^2$ |
| Pressure in apparatus | 7 Pa |
| Gas flow rate | hydrogen iodide gas 10 sccm |
| | nitrogen gas 0 to 3 sccm |
| | fluorine gas 0 to 2.5 sccm |
| Etching time | 90 minutes |
| Wall temperature | room temperature at the initial stage |

Dry etching was carried out for 5 minutes under the conditions described above at flow rates of nitrogen gas in a range of 0 to 3 sccm and flow rates of fluorine gas in a range of 0 to 2.5 sccm. The results are summarized in Fig. 4. In the figure, a small numeral which is written above mark ○ is a weight of a non-volatile substance stuck to the SUS substrate which is the test piece and is shown in a unit of mg/cm$^2$, by weight per unit area.

A non-volatile substance of 0.32 mg/cm$^2$ was obtained under a condition that only hydrogen iodide gas was allowed to flow. Further, the flow rates of nitrogen gas and fluorine gas were changed while the flow rate of hydrogen iodide gas was kept fixed to determine the amounts of the non-volatile substances stuck to the respective SUS substrates.

When only fluorine gas of 1 sccm was used other than hydrogen iodide gas, the stuck amount of the non-volatile substance was 0.27 mg/cm$^2$ and certainly reduced, though slightly.

In contrast with this, the amount of a non-volatile substance produced was 0.16 mg/cm$^2$ under the condition that in addition to hydrogen iodide gas, only nitrogen gas was allowed to flow at 1 sccm and was more preferred result from a viewpoint of inhibiting a non-volatile substance from being produced.

Further, the weight of a substance stuck to the test piece heated to 80°C was measured to find that the weight was further reduced.

The results obtained by measuring the weights of the non-volatile substances stuck to the samples heated to 80°C were written with small numerals at the right side of mark ○'s. Under the condition that the fluorine flow rate was 1 sccm and the nitrogen flow rates were 0.5 sccm or 1 sccm, the amounts of the non-volatile substances were 0.08 mg/cm$^2$ and 0.02 mg/cm$^2$, respectively, which were smaller values than those obtained when no heating was applied thereto, and heating to 80°C worked effectively.

Further, when only nitrogen gas was allowed to flow, heating was effective as well, and the weight of the non-volatile substance was 0.06 mg/cm$^2$ at a flow rate of 1 sccm of nitrogen gas, which was less as compared with no heating.

Summarizing these results, it could be confirmed that the effect of controlling the production of the non-volatile substances was exerted in the following range. That is,

$$0.04 \text{ sccm}^2 \leqq (\text{fluorine flow rate})^2 +$$

$$(\text{nitrogen flow rate})^2$$

Further, it was found that the effect was exerted as well on a reduction in the non-volatile substances in the case of nitrogen gas alone or fluorine gas alone. Summarizing the two facts described above, it could be confirmed that the effect was exerted in the ranges of:

fluorine flow rate $\geqq$ 0 sccm
nitrogen flow rate $\geqq$ 0 sccm

Further, heating the wall of the chamber could reduce the amount of the non-volatile substances produced sharply.

Thus, from the results obtained in Example 3 and Example 4, the range in which the dry etching speed of 1000 A/minute or more is provided and which is effective for controlling the production of the non-volatile substances to the utmost is given as follows. That is,

$$0.04 \text{ sccm}^2 \leqq (\text{nitrogen flow rate})^2 +$$

$$(\text{fluorine flow rate})^2 \leqq 4.5 \text{ sccm}^2$$

and

fluorine flow rate $\geqq$ 0 sccm
nitrogen flow rate $\geqq$ 0 sccm

Example 5

A solution prepared by dissolving 0.5 g of a photoresist which is a mixture comprising an acrylic resin and an acryl monomer in 2.5 g of acetone was coated by spin coating to form a thin layer on a 10 cm-square substrate which is provided with an ITO thin film having a thickness of 0.3 μm formed on a glass substrate by magnetron sputtering. This was maintained for 20 minutes at a temperature of 80 °C for drying and then irradiated with UV rays according to a prescribed pattern. The photoresist used is a negative type. Subsequently, after subjecting it to developing treatment in a 1 % solution of disodium carbonate ($Na_2CO_3$), it was further maintained for 10 minutes at a temperature of 80 °C for fixing. The photoresist having a pattern thus formed had a thickness in a range of 1.1 to 1.2 μm.

The substrate in which a polymer resist was thus formed on ITO was placed on a power electrode of an apparatus equipped with capacitance-coupling type high-frequency electrodes, and vacuumizing was carried out. After obtaining a vacuum of $1 \times 10^{-2}$ Pa or less, a gas obtained by mixing nitrogen trifluoride gas in a proportion of 10 % with hydrogen iodide gas was allowed to flow to carry out dry etching under the conditions shown below. In order to calculate accurately a dry etching speed, a polyimide tape was adhered to the ITO thin film substrate, and the dry etching speed was calculated from the difference between the thicknesses observed before and after the dry etching.

The ITO thin film substrate used for etching was prepared on a glass substrate by sputtering using a target of ITO. The target used for sputtering had a composition of 90 % of $In_2O_3$ and 10 % of $SnO_2$ and was prepared by direct current discharge.

| Etching conditions: | |
| --- | --- |
| Substrate | placed on power electrode side |
| Frequency | 13.56 MHz (RF) |
| RF electric power | 200 W |
| Electrode area | 78.5 cm$^2$ |
| Pressure in apparatus | 40 Pa |
| Gas flow rate | hydrogen iodide gas 10 sccm |
| | nitrogen trifluoride gas 1 sccm |
| Etching time | 5 minutes |
| Wall temperature | room temperature at the initial stage |

Further, plasma etching was carried out with a mixed gas of oxygen gas and nitrogen trifluoride gas. The conditions of the plasma are as follows.

| Etching conditions: | |
| --- | --- |
| Substrate | placed on power electrode side |
| Frequency | 13.56 MHz (RF) |
| RF electric power | 200 W |
| Electrode area | 78.5 cm$^2$ |
| Pressure in apparatus | 40 Pa |
| Gas flow rate | oxygen gas 8 sccm |
| Gas flow rate | nitrogen trifluoride gas 4 sccm |
| Etching time | 10 minutes |
| Wall temperature | room temperature at the initial stage |

As a result, the photoresist was almost removed by etching, and etching of ITO was carried out according to the pattern. The photoresist had an etching speed of about 700 Å/minute.

Example 6

Further, oxygen plasma treatment was carried out between an etching step of ITO which was the first step and an etching step of a photoresist which was the second step. The conditions of the oxygen plasma treatment are as follows.

| Oxygen plasma conditions: | |
| --- | --- |
| Substrate | placed on power electrode side |
| Frequency | 13.56 MHz (RF) |
| RF electric power | 200 W |
| Electrode area | 78.5 cm$^2$ |
| Pressure in apparatus | 40 Pa |
| Gas flow rate | oxygen gas 10 sccm |
| Etching time | 2 minutes |

(continued)

| Oxygen plasma conditions: | |
|---|---|
| Wall temperature | room temperature at the initial stage |

As a result, the photoresist was almost removed by etching, and etching of ITO was carried out according to the pattern. The photoresist had an etching speed of about 1000 Å/minute.

Comparative Example 1

Etching of ITO with hydrogen iodide gas was not carried out, and only the etching speed of a photoresist with oxygen plasma was measured. The etching conditions with the oxygen plasma were the same as in Example 5, except that nitrogen trifluoride gas was not used.

The same substrate as in Example 5 was used, which was prepared by spin coating of acryl-based photoresist on ITO. The etching speeds obtained with the oxygen plasma are as follows:

oxygen plasma time 3 minutes: 2300 Å/minute
oxygen plasma time 5 minutes: 2400 Å/minute

It was confirmed that the photoresist itself containing no iodine had a high etching speed exceeding 2000 Å/minute with the oxygen plasma.

Comparative Example 2

Etching with hydrogen iodide gas was carried out in the same manner as in Example 5. However, the photoresist was tried to be removed only with oxygen plasma. The conditions of the oxygen plasma were the same as in Example 5, except that nitrogen trifluoride gas was not used.

Etching of ITO was effectuated, but removal of the photoresist scarcely went on. However, the difference in a level could be observed, and the etching speed estimated from the difference in a level was about 100 Å/minute. This etching speed was an unsatisfactory result for commercial use.

Comparative Example 3

Pellets of ITO were provided in the same manner as in Example 2 to carry out a test of dry etching with a gas comprising mainly hydrogen iodide gas. Further, a test piece of SUS was provided as well in the same manner as in Example 2, and a non-volatile substance produced thereon was measured for its composition by means of AES and ICP.

| Etching conditions: | |
|---|---|
| Substrate | placed on power electrode side |
| Frequency | 13.56 MHz (RF) |
| RF electric power | 200 W |
| Electrode area | 78.5 cm$^2$ |
| Pressure in apparatus | 27 Pa |
| Gas flow rate | hydrogen iodide gas 10 sccm |
| Etching time | 2 hours |
| Wall temperature | room temperature at the initial stage |

The results obtained by measurement are shown in Table 1. It can be found from these results that the main components are In and I.

Example 7

Third reactive gas was used to carry out a test for confirming the effect of removing a non-volatile substance produced. The test was carried out in the same way as in Comparative Example 3.

The selected gas for the reactive gases were nitrogen trifluoride gas, fluorine gas and chlorine trifluoride gas, and the test was carried out as well with sulfur hexafluoride gas. Only the case where nitrogen trifluoride gas was used is shown the cleaning conditions as follows, but the conditions for the other gases are the same except that the gases are different. However, only when chlorine trifluoride was used, the wall temperature of the chamber was set to 120 °C.

| Cleaning conditions: | |
|---|---|
| Substrate | placed on power electrode side |
| Frequency | 13.56 MHz (RF) |
| RF electric power | 200 W |
| Electrode area | 78.5 cm$^2$ |
| Pressure in apparatus | 27 Pa |
| Gas flow rate | nitrogen trifluoride gas 10 sccm |
| Etching time | 2 hours |
| Wall temperature | room temperature at the initial stage |

The analytical results of the compositions of the non-volatile substances are shown in Table 1.

Incidentally, the total is not 100 %, and the balance corresponds to substances which are not identified and are composed of elements included in neither hydrogen iodide nor the third reactive gas.

Table 1

| | In | Sn | I | O | Si | F | S | C | Cl |
|---|---|---|---|---|---|---|---|---|---|
| Non-volatile matter Comparative Example 3 | 23.6 | 3.4 | 14.5 | 12.3 | 31.2 | 0.0 | 0.0 | 1.2 | 0.0 |
| Example 7 Reactive gas NF$_3$ | 3.9 | 0.5 | 3.2 | 11.2 | 18.6 | 2.7 | 0.0 | 1.0 | 0.0 |
| F$_2$ | 4.1 | 0.6 | 2.9 | 10.3 | 12.3 | 2.6 | 0.0 | 0.7 | 0.0 |
| ClF$_3$  120°C | 3.8 | 0.4 | 2.4 | 7.5 | 8.9 | 2.9 | 0.0 | 1.4 | 0.0 |
| SF$_6$ | 21.3 | 2.8 | 12.1 | 10.6 | 11.5 | 2.7 | 7.4 | 1.1 | 0.0 |

Remark  unit: vol %

**Claims**

1. A dry etching method for a metal oxide/photoresist film laminate in which a metal oxide film is processed by dry etching with plasma of a gas containing hydrogen iodide at a pressure ranging from 0.1 to 50 Pa with a photoresist film being used as a mask and then the photoresist film is removed with plasma of a gas containing oxygen at a pressure ranging from 0.1 to 1000 Pa to carry out circuit patterning in the metal oxide film, wherein the gas containing hydrogen iodide is prepared by mixing hydrogen iodide with at least one gas selected from the group consisting of a group consisting of fluorine gas and fluorine-based compound gases and a group consisting of nitrogen gas and nitrogen-based compound gases.

2. A dry etching method for a metal oxide/photoresist film laminate as described in claim 1, wherein a range in which $X_{FI}$ and $Y_{NI}$ satisfy is prescribed by equations (1), (2) and (3):

$$0.0004 \leqq X_{FI}^2 + Y_{NI}^2 \leqq 0.045 \tag{1}$$

$$X_{FI} \geqq 0 \tag{2}$$

$$Y_{NI} \geqq 0 \tag{3}$$

wherein a volume flow rate of hydrogen iodide gas is designated as $G_{HI}$; a volume flow rate of a gas selected from the group consisting of fluorine gas and fluorine-based compound gases is designated $G_{FI}$; a volume flow rate of a gas selected from the group consisting of nitrogen gas and nitrogen-based compound gases is designated as $G_{NI}$; and a volume flow ratio $X_{FI}$ is defined by $X_{FI} = G_{FI}/G_{HI}$, and a volume flow ratio $Y_{NI}$ is defined by $Y_{NI} = G_{NI}/G_{HI}$.

3. A dry etching method for a metal oxide/photoresist film laminate as described in claim 2, wherein a range in which $Z_{FNI}$ satisfy is prescribed by an equation (4):

$$0.02 \leqq Z_{FNI} \leqq 0.15 \tag{4}$$

wherein a volume flow rate of hydrogen iodide gas is designated as $G_{HI}$; a volume flow rate of a gas selected from the group consisting of fluorine·nitrogen-based compound gases is designated as $G_{FNI}$; and a volume flow ratio $Z_{FNI}$ is defined by $Z_{FNI} = G_{FNI}/G_{HI}$.

4. A dry etching method for a metal oxide/photoresist film laminate as described in claim 1 in which a metal oxide film is processed by dry etching with a gas containing hydrogen iodide as described in claim 1 and then a photoresist film is removed with plasma of a gas containing oxygen at a pressure ranging from 0.1 to 1000 Pa, wherein the gas containing oxygen is prepared by mixing oxygen with at least one gas selected from the group consisting of a group consisting of fluorine gas and fluorine-based compound gases and a group consisting of nitrogen gas and nitrogen-based compound gases.

5. A dry etching method for a metal oxide/photoresist film laminate as described in claim 4, wherein a range in which $X_{FO}$ and $Y_{NO}$ satisfy is prescribed by equations (5), (6) and (7):

$$0.05 \leqq X_{FO} + Y_{NO} \leqq 6.0 \tag{5}$$

$$X_{FO} \geqq 0 \tag{6}$$

$$Y_{NO} \geqq 0 \tag{7}$$

wherein a volume flow rate of oxygen gas is designated as $G_O$; a volume flow rate of a gas selected from the group consisting of fluorine gas and fluorine-based compound gases is designated $G_{FO}$; a volume flow rate of a gas selected from the group consisting of nitrogen gas and nitrogen-based compound gases is designated as $G_{NO}$; and a volume flow ratio $X_{FO}$ is defined by $X_{FO} = G_{FO}/G_O$, and a volume flow ratio $Y_{NO}$ is defined by $Y_{NO} = G_{NO}/G_O$.

6. A dry etching method for a metal oxide/photoresist film laminate as described in claim 5, wherein a range in which $Z_{FNO}$ satisfy is prescribed by an equation (8):

$$0.05 \leqq Z_{FNO} \leqq 3.0 \tag{8}$$

wherein a volume flow rate of oxygen gas is designated as $G_O$; a volume flow rate of a gas selected from the group consisting of fluorine·nitrogen-based compound gases is designated as $G_{FNO}$; and a volume flow ratio $Z_{FNO}$ is defined by $Z_{FNO} = G_{FNO}/G_O$.

7. A dry etching method for a metal oxide/photoresist film laminate as described in claim 1 in which a metal oxide film is processed by dry etching with a gas containing hydrogen iodide as described in claim 1 and then a photoresist film is removed with plasma of a gas containing oxygen at a pressure ranging from 0.1 to 1000 Pa, wherein said photoresist film is exposed to plasma of oxygen gas at a pressure ranging from 0.1 to 1000 Pa after the dry etching of said metal oxide film has been carried out, and then said photoresist film is removed with plasma of a gas containing oxygen as described in claim 4.

8. A dry etching method for a metal oxide/photoresist film laminate as described in claim 1 in which of a metal oxide film is processed by dry etching with a gas containing hydrogen iodide as described in claim 1 and then a photoresist film is removed with plasma of a gas containing oxygen at a pressure ranging from 0.1 to 1000 Pa, wherein said photoresist film is exposed to plasma of oxygen gas at a pressure ranging from 0.1 to 1000 Pa after the dry etching of said metal oxide film has been carried out, and then said photoresist film is removed with plasma of a gas containing oxygen as described in claim 5.

9. A dry etching method for a metal oxide/photoresist film laminate as described in claim 1 in which a metal oxide film is processed by dry etching with a gas containing hydrogen iodide as described in claim 1 and then a photoresist film is removed with plasma of a gas containing oxygen at a pressure ranging from 0.1 to 1000 Pa, wherein said photoresist film is exposed to plasma of oxygen gas at a pressure ranging from 0.1 to 1000 Pa after the dry etching of said metal oxide film has been carried out, and then said photoresist film is removed with plasma of a gas containing oxygen as described in claim 6.

10. A dry etching method for a metal oxide/photoresist film laminate as described in claim 1 in which plasma is produced at a pressure ranging from 0.1 to 50 Pa in a dry-etching chamber after the metal oxide/photoresist film laminate has been taken out from the dry etching chamber, wherein said plasma is produced by using at least one gas selected from the group consisting of a group consisting of fluorine gas and fluorine-based compound gases and a group consisting of nitrogen gas and nitrogen-based compound gases.

11. A dry etching method for a metal oxide/photoresist film laminate as described in claim 4 in which plasma is produced at a pressure ranging from 0.1 to 50 Pa in a dry etching chamber after the metal oxide/photoresist film laminate has been taken out from the dry-etching chamber, wherein said plasma is produced by using at least one gas selected from the group consisting of a group consisting of fluorine gas and fluorine-based compound gases and a group consisting of nitrogen gas and nitrogen-based compound gases.

12. A dry etching method for a metal oxide/photoresist film laminate as described in claim 1, wherein the surface of the inside of a dry etching chamber is maintained at a temperature ranging from 60 °C or higher to 300 °C or lower.

13. A dry etching method for a metal oxide/photoresist film laminate as described in claim 1, wherein a gas containing hydrogen iodide contains at least one gas selected from the group consisting of helium, neon, argon, krypton, xenon and hydrogen.

14. A dry etching method for a metal oxide/photoresist film laminate as described in claim 1, wherein said metal oxide film is any of ITO (indium-tin-oxide), tin oxide and zinc oxide.

15. The dry-etching method for a metal oxide/photoresist film laminate as described in claim 4, wherein said metal oxide film is any of ITO (indium-tin-oxide), tin oxide and zinc oxide.

*FIG.1*

# FIG.2

# FIG.3

Area where etching goes on and a non-volatile matter is inhibited from being produced

Volume ratio of NF$_3$ flow rate to HI flow rate
(NF$_3$ flow rate /HI flow rate)

# FIG.4

○ Etching speed: 1000 Å /minute or more

● Etching speed: less than 1000 Å /minute

Weight per unit area of non-volatile matter[mg/cm²]

Numeral at upper side: no heating[mg/cm2]
○ Numeral at right side: heating at 80℃[mg/cm2]

Nitrogen flow rate[sccm]

Fluorine flow rate[sccm]

## FIG.5

Part marked with oblique lines: scope of the present invention

$Y_{NI}$: Gas volume flow ratio [volume flow rate of a gas selected from the group consisting of nitrogen gas and nitrogen base compound gas / volume flow rate of HI gas]

$0 \leqq X_{FI}$

$X_{FI}{}^2 + Y_{NI}{}^2 \leqq 0.045$

$Y_{NI} \geqq 0$

$0.0004 \leqq X_{FI}{}^2 + Y_{NI}{}^2$

$X_{FI}$: Gas volume flow ratio [volume flow rate of a gas selected from the group consisting of fluorine gas and fluorine base compound gas / volume flow rate of HI gas]

28

## FIG.6

Group consisting of fluorine gas and fluorine base compound gas

$F_2$  $ClF_3$  $C_4F_8$  $NF_3$  $C_2F_6$

Group consisting of nitrogen gas and nitrogen base compound gas

$NF_3$  $NH_3$  $N_2$

$F_2$  $ClF_3$  $C_4F_8$  $NF_3$  $NH_3$  $N_2$  $C_2F_6$

Group consisting of fluorine·nitrogen base compound gas

## FIG.7

Part marked with oblique lines: scope of the present invention

$0.05 \leqq X_{Fo} + Y_{No} \leqq 6.0$
$0 \leqq X_{Fo}$
$0 \leqq Y_{No}$

$X_{Fo} + Y_{No} \leqq 6.0$

$Y_{NO}$ : Gas volume flow ratio [volume flow rate of a gas selected from the group consisting of nitrogen gas and nitrogen base compound gas / volume flow rate of oxygen gas]

$0.05 \leqq X_{Fo} + Y_{No}$

$X_{FO}$ : Gas volume flow ratio [volume flow rate of a gas selected from the group consisting of fluorine gas and fluorine base compound gas / volume flow rate of oxygen gas]